# EUROPÄISCHE PATENTSCHRIFT

(11) **EP 0 432 450 B1**
(45) Veröffentlichungstag und Bekanntmachung des Hinweises auf die Patenterteilung: **10.04.1996**
(21) Anmeldenummer: 90121282.9
(22) Anmeldetag: 07.11.1990
(51) Int. Cl.: G03F 7/32

(54) **Entwicklerkonzentrat und daraus hergestellter Entwickler für belichtete negativ arbeitende Reproduktionsschichten mit Deckschicht sowie Verfahren zur Herstellung von Druckformen**
Developer concentrate and developer therefrom for exposed negative working printing plates with overcoat and method for producing printing plates
Concentré de développeur ainsi que développeur pour des couches de reproduction négatives avec couche de recouvrement et méthode de fabrication de plaques d'impression

(30) Priorität: 16.11.1989 DE 3938108
(43) Veröffentlichungstag der Anmeldung: 19.06.1991
(73) Patentinhaber: HOECHST AKTIENGESELLSCHAFT, D-65926 Frankfurt am Main (DE)
(72) Erfinder: Zertani, Rudolf, Dipl.-Chem., W-6500 Mainz (DE); Joerg, Klaus, Dr. Dipl.-Chem., W-6507 Ingelheim (DE)

(56) Entgegenhaltungen:
- EP-A- 0 080 042
- EP-A- 0 180 122
- EP-A- 0 301 264

## Beschreibung

Die Erfindung betrifft ein mit Leitungswasser auf den gebrauchsfertigen Zustand verdünnbares Entwicklerkonzentrat, das zum Entwickeln von negativ arbeitenden, belichteten Reproduktionsschichten mit Deckschicht in Kopiermaterialien geeignet ist sowie ein Verfahren zur Herstellung von Druckformen.

Kopiermaterialien der genannten Art werden insbesondere bei der Herstellung von Druckplatten oder von Photoresists verwendet und bestehen aus einem Schichtträger und einer negativ arbeitenden, lichtempfindlichen Reproduktionsschicht, die als lichtempfindliche Komponenten Diazoniumsalz-Polykondensationsprodukte und/oder photopolymerisierbare Verbindungen enthalten kann. Als Schichtträger werden in diesen Kopiermaterialien Metalle wie Zink, Chrom, Kupfer, Messing, Stahl, Aluminium oder Kombinationen dieser Metalle, Kunststoffolien, Papier oder ähnliche Materialien verwendet. Diese Schichtträger können ohne eine modifizierende Vorbehandlung, bevorzugt aber nach Durchführung einer Oberflächenmodifizierung, wie einer mechanischen, chemischen oder elektrochemischen Aufrauhung, einer Oxidation und/oder einer Behandlung mit Hydrophilierungsmitteln (z. B. bei Offsetdruckplatten-Trägern), mit der lichtempfindlichen Reproduktionsschicht beschichtet werden.

Die bisher für diese Kopiermaterialien geeigneten Entwickler bzw. Entwicklergemische weisen insbesondere folgende Nachteile auf:
- Sie enthalten oftmals höhere Anteile an organischem Lösemittel, die aus ökologischen Gründen (niedrigsiedend, feuergefährlich, unangenehm riechend, negative Beeinflussung von Abwasser und Abluft, aufwendige Vorkehrungen zur Beseitigung der Lösemittel nach der Entwicklung) möglichst nicht mehr in zeitgemäßen Entwicklern vorhanden sein sollten.
- Das in der Praxis bisher oftmals eingesetzte Laurylsulfat oder andere Alkylsulfate oder Alkansulfonate sind zwar an sich wirksame Entwicklerkomponenten für die angegebenen lichtempfindlichen Reproduktionsschichten, sie erfordern aber eine verhältnismäßig lange Entwicklungszeit, sie schäumen in Verarbeitungsmaschinen zu stark, insbesondere bei Vertikalentwicklung, und die Löslichkeit bei niedrigen Temperaturen (z. B. ab etwa 10°C und tiefer) in Wasser sinkt in einem Ausmaß, daß bei herbstlichen oder winterlichen Temperaturen flockige Rückstände in den Stammlösungen anfallen können, die für den Verarbeiter oftmals störend sind. Fettflecken und Klebstoffreste, wie sie bei der Handhabung von Offsetdruckplatten unter Praxisbedingungen auftreten können, werden von diesen Entwicklerkomponenten höchstens nach langer Einwirkzeit und durch zusätzliche mechanische Hilfen entfernt.
- Sie sind häufig zwar bei Anwendung für die speziellen Reproduktionsschichten, für die sie entwickelt wurden, und bei denen sie in den jeweiligen Beispielen auch erfolgreich eingesetzt wurden, auch geeignet, zeigen aber bei von diesen speziellen Reproduktionsschichten verschiedenen Schichten mehr oder weniger große Schwierigkeiten; d. h. sie sind nicht universell einsetzbar.
- Sie sind nicht geeignet, generell die in vielen Fällen, hauptsächlich bei maschineller Entwicklung, auftretenden Verunreinigungen (Fladen und Fädchen), die sich als Redeponierungen auf den Druckformen ablagern, zu unterbinden, so daß keine optimale Qualität des Endproduktes - auch bei längerem Gebrauch des Entwicklers - erreicht werden kann.

In der DE-A 34 39 597 (= US-A 4 716 098) ist ein Entwicklergemisch beschrieben, das sich vom oben beschriebenen Stand der Technik abgrenzt, dessen Nachteile nicht aufweist und zur Entwicklung von Flachdruckplatten geeignet ist. Die dort beschriebenen Schichten enthalten ein Diazoniumsalz-Polykondensationsprodukt und ein im Alkalischen lösliches carboxylgruppenhaltiges Bindemittel. Das Entwicklergemisch ist nur in sehr verdünnter Form stabil und kann deshalb nur in verdünnter, wäßriger Lösung vorliegen. Der beschriebene Entwickler enthält bis zu 85 % Wasser, wodurch unnötig große Gebinde vonnöten sind, die zudem negative Auswirkungen auf Transport und Applikation haben.

Es stellte sich somit die Aufgabe, ein Konzentrat eines Entwicklers für negativ arbeitende, belichtete Reproduktionsschichten herzustellen, das
- einen hohen Feststoffgehalt aufweist und auch nach einem eventuellen Einfrieren keine Ausfällungen, Phasentrennungen oder Trübungen beim Wiederauftauen zeigt,
- bei Bedarf vor der Anwendung in der Druckerei mit Ca- und Mg-ionenhaltigem Wasser, insbesondere Leitungswasser, auf das in der Praxis erforderliche Maß verdünnt werden kann, ohne daß sich dabei Ausfällungen zeigen,
- , um in automatischen Verarbeitungsanlagen eingesetzt werden zu können, schnell entwickelt und dabei ebenso optimale Entwicklungseigenschaften (gute Auflösung der Nichtbildstellen und Nichtangriff der Bildstellen) aufweist,
- sowohl als Konzentrat als auch in den verschiedenen Verdünnungsgraden ohne Fladen- und Fädchenbildung entwickelt und dabei eine hohe Ergiebigkeit aufweist, d. h. auch über einen längeren Zeitraum in seinem Entwicklungsverhalten brauchbar ist, ohne Verunreinigungen zu bilden,
- sowohl bei bindemittelhaltigen als auch bei bindemittelfreien Systemen verwendet werden kann und - zur Entwicklung von Reproduktionsschichten mit Deckschicht geeignet ist.

Gelöst wird die Aufgabe durch ein Entwicklerkonzentrat, bestehend aus einem Gemisch aus Wasser, einem organischen Lösemittel, einem alkalisch reagierenden Mittel, einem anionischen Tensid, einer n-Alkansäure und/oder deren Salze, einem Emulgator, einem Alkalisalz eines oligomeren Phosphats und/oder der N-(2-Hydroxyethyl)ethylendiaminotriessigsäure als Komplexbildner und einer Puffersubstanz, dadurch gekennzeichnet, daß die Puffersubstanz ein Tris(hydroxyalkyl)aminomethan ist.

Unter Tris(hydroxyalkyl)aminomethan werden insbesondere Tris(hydroxy-C₁-C₄-alkyl)aminomethane verstanden. Vorzugsweise ist hierunter Tris(hydroxymethyl)aminomethan zu verstehen.

Die erfindungsgemäß verwendete puffernde Substanz ist vorzugsweise im pH-Bereich von 8 bis 12 wirksam.

Der Gehalt an der Puffersubstanz im Entwicklerkonzentrat liegt bei 0,5 bis 20,0 Gew.-%, vorzugsweise bei 0,7 bis 10,0 Gew.-%.

Der aus dem erfindungsgemäßen Entwicklerkonzentrat hergestellte Entwickler zeichnet sich durch eine hohe Pufferkapazität aus, die aus seiner geringen Bereitschaft zur CO₂-Aufnahme resultiert. Besonders überraschend ist, daß sich durch die Wahl gerade dieser Puffersubstanz der diese Substanz enthaltende Entwickler auch zur Entwicklung von Reproduktionsschichten mit Deckschicht eignet. Dies sind hauptsächlich Schichten, die photopolymerisierbare Verbindungen enthalten.

Der aus dem erfindungsgemäßen Entwicklerkonzentrat herstellbare Entwickler ist aber auch zur Entwicklung von Reproduktionsschichten ohne Deckschicht uneingeschränkt geeignet. Hierunter fallen insbesondere diejenigen Schichten, die als negativ arbeitende, lichtempfindliche Verbindungen Diazoniumsalz-Polykondensationsprodukte enthalten, sowie photopolymerisierbare Schichten, die allerdings ohne Deckschicht eine geringere Haltbarkeit aufweisen.

Wenn auch die Komponenten des Entwicklerkonzentrates einzeln oder auch in teilweiser Kombination aus dem Stand der Technik bekannt sind, so ist es zudem überraschend, daß durch die Wahl des speziellen Komplexbildners sowie der beschriebenen Puffersubstanz Entwicklerkonzentrate erhalten werden, die keine Ausfällungen oder Phasentrennungen zeigen; auch dann nicht, wenn das Konzentrat mehrere Male eingefroren und wieder aufgetaut wird.

Als Komplexbildner werden die Salze niedermolekularer Phosphate, sogenannte Oligophosphate, mit 2 bis 10, insbesondere 2 bis 6, vorzugsweise 2 bis 4, Phosphoreinheiten, eingesetzt. Besonders bevorzugt sind die Alkalisalze, insbesondere die Natriumsalze. Zu nennen sind Tetranatriumdiphosphat, Pentanatriumtriphosphat und Hexanatriumtetraphosphat.

Ebenso werden die Alkalisalze, insbesondere das Natriumsalz der N-(2-Hydroxyethyl)-ethylendiaminotriessigsäure, verwendet. Diese können allein oder in Kombination mit den niedermolekularen Phosphaten eingesetzt werden. Besonders bevorzugt sind jedoch Entwickler, die entweder ein niedermolekulares Phosphat oder das Natriumsalz der genannten Triessigsäure enthalten.

Der Gehalt an dem Komplexbildner im Entwicklerkonzentrat beträgt 0,1 bis 9,0 Gew.-%, insbesondere 0,5 bis 6,0 Gew.-% und vorzugsweise 2,0 bis 6,0 Gew.-%. Sofern das Alkalisalz der N-(2-Hydroxyethyl)ethylendiaminotriessigsäure im Entwicklerkonzentrat enthalten ist, liegt dessen bevorzugter Gehalt bei 2,0 bis 5,0 Gew.-%.

Das erfindungsgemäße Entwicklerkonzentrat enthält ferner n-Alkansäuren und/oder deren Salze mit 8 bis 12 Kohlenstoffatomen. Besonders gute Ergebnisse werden mit Capryl-, Pelargon-, Caprin- und Laurinsäure erzielt. Im Entwicklerkonzentrat liegen diese Säuren in einem Gehalt von 1,0 bis 16,0 Gew.-%, insbesondere 1,5 bis 14,0 Gew.-%, vor.

Als Tenside kommen viele anionische oberflächenaktive Mittel in Frage. Insbesondere haben sich vor allem solche bewährt, die aus der Gruppe Alkali-, vorzugsweise Natrium-, -octylsulfate, -dodecylbenzolsulfonat, -alkylphenolethersulfate, -naphthalensulfonate, -sulfosuccinate, -alkyletherphosphate oder Alkali-, vorzugsweise Natrium-ölsäuremethyltaurid ausgewählt sind. Das oder die anionische(n) oberflächenaktive(n) Mittel liegen im Entwicklerkonzentrat mit 0,2 bis 15,0 Gew.-%, insbesondere mit 1,0 bis 10,0, Gew.-%, vorzugsweise mit 1,0 bis 8,0 Gew.-%, vor.

Als Emulgatoren werden hauptsächlich Produkte eingesetzt, die aus der Gruppe poly-N-vinyl-N-methylacetamid, wasserlösliche Copolymere des N-Vinyl-N-methylacetamid, Polyvinylalkohol, Dextrin, Gummi arabicum und Celluloseether, insbesondere Carboxymethylcellulose, ausgewählt sind. Der bevorzugte Gehalt an Emulgator im Entwicklerkonzentrat beträgt 0,1 bis 10,0 Gew.-%, insbesondere 0,2 bis 6,0 Gew.-%, vorzugsweise 1,0 bis 5,0 Gew.-%.

Zahlreiche bekannte organische Lösemittel können Verwendung finden, jedoch haben sich besonders solche in der Praxis bewährt, die aus der Gruppe Benzylalkohol, Ethylenglykolmonophenylether, 1-Phenylethanol, 2-Phenylethanol und Propylenglykolmonomethyl- und phenylether ausgewählt sind. Der Anteil an organischem Lösemittel im Entwicklerkonzentrat liegt zweckmäßig bei 0,5 bis 15,0 Gew.-%, insbesondere bei 1,0 bis 10,0, Gew.-%, vorzugsweise bei 5,0 bis 10,0 Gew.-%.

Als alkalisch reagierende Mittel werden vorwiegend Alkalimetallhydroxide, insbesondere LiOH, NaOH und KOH verwendet. Der Anteil an diesem Mittel im Entwicklerkonzentrat liegt bei 1,5 bis 8,0 Gew.-%, insbesondere bei 1,5 bis 6,0 Gew.-% und vorzugsweise bei 1,0 bis 5,0 Gew.-%.

Dadurch, daß nur relativ geringe Anteile an organischem Lösemittel im Entwicklergemisch vorhanden sind, ändert dieses seine Zusammensetzung während des Gebrauchs praktisch nicht und hat somit in den Entwicklungsvorrichtungen eine verhältnismäßig lange Standzeit.

Im allgemeinen liegt der pH-Wert der erfindungsgemäßen Entwicklerkonzentrate vorzugsweise bei 8 bis 12.

Die erfindungsgemäßen Entwicklerkonzentrate zeigen keine störende Geruchsbelästigung, und es treten auch bei Temperaturen um den Gefrierpunkt im beanspruchten Mengenbereich der Komponenten keine Ausfällungen auf.

Klebstoffreste (z. B vom Aufkleben der Filmvorlagen beim Kopieren) und Fettflecken (z.B. vom Stanzen der Druckplatten) lassen sich mühelos auch bei geringerer Einwirkzeit des Entwicklers entfernen. Die Entwicklungsgeschwindigkeit ist gegenüber herkömmlichen Entwicklern erhöht, ohne daß eine Verringerung der Entwicklerresistenz der Bildbereiche zu beobachten ist. Auch die Salze der Alkansäuren können als kürzerkettige "Seifen" verhältnismäßig leicht abgebaut werden. Eine Fladen- oder Fädchenbildung, die zu einer unerwünschten Verunreinigung des Fertigproduktes und der Verarbeitungsanlage führt, ist nicht zu beobachten.

Neben den genannten vorteilhaften Eigenschaften ist es insbesondere überraschend, daß auch das Konzentrat stets homogen bleibt, selbst nachdem es längere Zeit eingefroren war und wieder aufgetaut wurde.

Ein weiterer Vorteil besteht darin, daß das erfindungsgemäße Entwicklerkonzentrat erst beim Kunden auf das notwendige Maß verdünnt werden muß. Dabei kann auch stark Ca- und Mg-ionenhaltiges Wasser verwendet werden, ohne daß es zu Ausfällungen kommt. Die konzentrierte Form hat den zusätzlichen Vorteil, daß das Transportvolumen kleiner ist und deshalb die Transportkosten niedriger sind. Dies ist insbesondere bei Exportartikeln relevant.

Das erfindungsgemäße Entwicklerkonzentrat ist grundsätzlich für die meisten der negativ arbeitenden Reproduktionsschichten, wie sie zum Stand der Technik gehören, verwendbar. Zum Verdünnen des Konzentrats zum gebrauchsfertigen Entwickler für eine auf einem Träger befindliche negativ arbeitende, belichtete Reproduktionsschicht kann einfaches Leitungswasser, das insbesondere Ca- und Mg-Ionen enthält, verwendet werden. Das Verdünnungsverhältnis von Konzentrat zu Leitungswasser liegt im Bereich von 1:0,5 bis 1:6, vorzugsweise bei 1:1 bis 1:3.

Die zu entwickelnden Reproduktionsschichten können sowohl die bekannten Bindemittel enthalten als auch bindemittelfrei sein. Bevorzugt wird das Entwicklerkonzentrat jedoch bei bindemittelhaltigen Reproduktionsschichten eingesetzt. Als lichtempfindiiche Komponenten enthalten solche Reproduktionsschichten beispielsweise Diazoniumsalz-Polykondensationsprodukte.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE-A 20 24 244 beschrieben. Allgemein sind alle Diazoniumsalz-Polykondensationsprodukte geeignet, die in der DE-A 27 39 774 beschrieben sind.

Die Diazoniumsalzeinheiten A-N₂X leiten sich bevorzugt von Verbindungen der Formel (R⁸-R⁹-)ₚR¹⁰-N₂X ab, wobei
- X: das Anion der Diazoniumverbindung,
- p: eine ganze Zahl von 1 bis 3,
- R⁸: einen aromatischen Rest mit mindestens einer zur Kondensation mit aktiver Carbonylverbindung befähigten Position,
- R¹⁰: eine Phenylengruppe,
- R⁹: eine Einfachbindung oder eine der Gruppen:

-(CH₂)_{q}-NR¹¹-, O-R¹-O,

-O-(CH₂)ᵣ-NR¹¹-, -O-,

-S-(CH₂)ᵣ-NR¹¹-, -S-

oder

-S-CH₂CO-NR¹¹-, -CO-NR¹¹-
bedeuten, worin
- q: eine Zahl von 0 bis 5,
- r: eine Zahl von 2 bis 5,
- R¹¹: Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
- R¹: eine Arylengruppe mit 6 bis 12 C-Atomen ist.

Die mit dem Entwickler entwickelbaren Gemische enthalten im allgemeinen 5 bis 90, bevorzugt 10 bis 70 Gew.-% Diazoniumverbindung.

Zur Stabilisierung des lichtempfindlichen Gemisches ist es vorteilhaft, diesem eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure.

Den Gemischen können ferner Weichmacher, Haftvermittler, Farbstoffe, Pigmente und Farbbildner zugesetzt werden.

Art und Menge dieser Zusätze richten sich nach dem für das lichtempfindliche Gemisch vorgesehenen Anwendungsgebiet. Dabei ist grundsätzlich zu beachten, daß die beigefügten Stoffe keinen übergroßen Anteil des für die Vernetzung notwendigen aktinischen Lichts absorbieren und dadurch die praktische Lichtempfindlichkeit herabsetzen.

Die lichtempfindlichen Gemische können ferner Farbstoffe und/oder Pigmente enthalten, die sowohl als Kontrastmittel als auch schichtverfestigend wirken können. In Frage kommende Farbstoffe sind beispielsweise in den US-A 3 218 167 und 3 884 693 angegeben. Besonders geeignet sind z. B. Viktoriareinblau FGA, Renolblau B2G-H (C.I. 74160), Kristallviolett oder Rhodamin 6 GDN (C.I. 45160). Zur Erhöhung des Bildkontrastes nach dem Belichten können Metanilgelb (C.I. 13065), Methylorange (C.I. 13025) oder Phenylazodiphenylamin verwendet werden.

Ebenso können photopolymerisierbare Verbindungen als lichtempfindliche Verbindungen verwendet werden. Die diese Verbindungen enthaltenden Schichten weisen als wesentliche Bestandteile ein polymeres Bindemittel, eine radikalisch polymerisierbare Verbindung mit mindestens einer, bevorzugt mindestens zwei endständigen, ethylenisch ungesättigten Gruppen sowie einen durch aktinisches Licht aktivierbaren Polymerisationsinitiator bzw. eine Initiatorkombination auf. Vorzugsweise sind Reproduktionsschichten dieser Art durch eine Deckschicht insbesondere gegen Luftsauerstoff geschützt.

Üblicherweise enthalten solche Deckschichten ein Polymeres, das die Sauerstoffdurchlässigkeit durch die Overcoatschicht herabsetzt. Insbesondere wird Polyvinylalkohol, Polyvinylpyrrolidon oder Gelatine verwendet. Es können aber auch spezielle sauerstoffbindende, wasserlösliche Polymere mit aliphatischen Aminogruppen in der Deckschicht enthalten sein. Solche Verbindungen werden in der älteren deutschen Patentanmeldung P 38 25 836.6 beschrieben.

Die Deckschicht soll für aktinisches Licht durchlässig sein und hat im allgemeinen eine Dicke von 0,5 bis 10, vorzugsweise von 1 bis 4 µm. Sie enthält im allgemeinen 3 bis 60 Gew.-%, vorzugsweise 5 bis 40 Gew.-%, des sauerstoffbindenden Polymeren. Die Deckschicht wird in bekannter Weise aus wäßriger Lösung oder aus einem Gemisch aus Wasser und organischem Lösemittel auf die photopolymerisierbare Schicht aufgebracht. Der Beschichtungslösung können zur besseren Benetzung bis zu 10 Gew.-%, vorzugsweise bis zu 5 Gew.-% eines oberflächenaktiven Mittels, bezogen auf ihren Feststoffgehalt, zugesetzt werden. Zu den verwendbaren oberflächenaktiven Mitteln gehören die anionischen, kationischen und nichtionischen, z. B. Natrium-alkylsulfate und -alkansulfonate mit 12 bis 18 C-Atomen wie Natriumdodecylsulfat, N-Cetyl- und C-Cetylbetaine, Alkylaminocarboxylate und -dicarboxylate sowie Polyethylenglykol mit einem durchschnittlichen Molekulargewicht bis 400.

In der photopolymerisierbaren Schicht sind als polymerisierbare Verbindungen insbesondere solche geeignet, die in den US-A 2 760 863 und 3 060 023 beschrieben werden.

Bevorzugte Beispiele sind Acryl- und Methacrylsäureester von zwei- oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen oder N-substituierte Acryl- und Methacrylsäureamide. Mit Vorteil werden auch Umsetzungsprodukte von Mono- oder Diisocyanaten mit Partialestern mehrwertiger Alkohole eingesetzt. Derartige Monomere sind in den DE-A 20 64 079, 23 61 041 und 28 22 190 beschrieben.

Ebenso können polymerisierbare Verbindungen, die mindestens eine photooxidierbare und ggf. mindestens eine Urethangruppe im Molekül enthalten, verwendet werden. Derartige Monomere sind in den DE-A 37 10 279, 37 10 281 und 37 10 282 beschrieben.

Ebenso sind die in den älteren deutschen Patentanmeldungen P 38 25 836.6 und P 38 32 032.0 beschriebenen Verbindungen mit photooxidierbaren Gruppen anwendbar.

Als Photoinitiatoren können eine Vielzahl von Substanzen Verwendung finden. Beispiele sind solche, die sich vom Grundkörper der Benzophenone, Acetophenone, Benzoine, Benzile, Benzilmonoketale, des Fluorenons, Thioxanthons, der Mehrkernchinone, Acridine und Chinazoline ableiten; ferner Trichlormethyl-s-triazine, 2-Halogenmethyl-5-vinyl-1,3,4-oxadiazolderivate, mit Trichlormethylgruppen substituierte Halogenoxazole oder Trihalogenmethylgruppen enthaltende Carbonylmethylenheterocyclen, wie sie in der DE-A 33 33 450 angegeben sind.

Bevorzugt werden als Photoinitiatoren photoreduzierbare Farbstoffe, insbesondere in Kombination mit durch Belichtung spaltbaren Trihalogenmethylverbindungen und gegebenenfalls mit als Photoinitiatoren wirksamen Acridin-, Phenazin- oder Chinoxalinverbindungen, wie sie in den DE-A 37 10 281 und 37 10 282 beschrieben sind.

Die Gesamtmenge an Polymerisationsinitiatoren liegt im allgemeinen bei 0,05 bis 20, vorzugsweise bei 0,1 bis 10 Gew.-%.

Die photopolymerisierbaren Schichten können je nach geplanter Anwendung, und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher und Kettenüberträger. Diese Bestandteile sind zweckmäßig so auszuwählen, daß sie in dem für den Initiierungsvorgang wichtigen aktinischen Strahlungsbereich möglichst wenig absorbieren.

Der erfindungsgemäße Entwickler ist ebenso geeignet für das Entwickeln von negativ arbeitenden, lichtempfindlichen Schichten, die sowohl ein Diazoniumsalz-Polykondensationsprodukt als auch eine photopolymerisierbare Verbindung enthalten.

Beispiele für verwendbare Bindemittel sind chloriertes Polyethylen, chloriertes Polypropylen, Poly(meth)acrylsäurealkylester, bei denen die Alkylgruppe z. B. Methyl, Ethyl, n-Butyl, i-Butyl, n-Hexyl oder 2-Ethylhexyl ist, Copolymere der genannten (Meth)acrylsäurealkylester mit mindestens einem Monomeren, wie Acrylnitril, Vinylchlorid, Vinylidenchlorid, Styrol oder Butadien; Polyvinylchlorid, Vinylchlorid/ Acrylnitril-Copolymere, Polyvinylidenchlorid, Vinylidenchlorid/Acrylnitril-Copolymere, Polyvinylacetat, Polyvinylalkohol, Polyacrylnitril, Acrylnitril/Styrol-Copolymere, Acrylnitril/Butadien/Styrol-Copolymere, Polystyrol, Polymethylstyrol, Polyamide (z. B. Nylon-6), Polyurethane, Methylcellulose, Ethylcellulose, Acetylcellulose, polyvinylformal und polyvinylbutyral.

Besonders geeignet sind Bindemittel, die in Wasser unlöslich, in organischen Lösemitteln löslich und in wäßrig-alkalischen Lösungen löslich oder zumindest quellbar sind.

Besonders erwähnt werden sollen Carboxylgruppen enthaltende Bindemittel, z. B. Copolymerisate aus (Meth)acrylsäure und/oder deren ungesättigten Homologen, wie Crotonsäure, Copolymerisate des Maleinsäureanhydrids oder seiner Halbester, Umsetzungsprodukte hydroxylgruppenhaltiger Polymerer mit Dicarbonsäureanhydriden sowie deren Mischungen.

Weiterhin sind geeignet Umsetzungsprodukte aus Polymeren, die H-acide Gruppen tragen, welche ganz oder teilweise mit aktivierten Isocyanaten umgesetzt wurden, wie beispielsweise Umsetzungsprodukte aus hydroxylgruppenhaltigen Polymeren mit aliphatischen oder aromatischen Sulfonylisocyanaten oder Phosphinsäureisocyanaten.

Darüber hinaus sind geeignet: Hydroxylgruppen enthaltende Polymere, wie beispielsweise Copolymere von Hydroxyalkyl(meth)acrylaten, Copolymere des Allylalkohols, Copolymere des Vinylalkohols, Polyurethane oder Polyester, sowie Epoxyharze, sofern sie eine ausreichende Anzahl von freien OH-Gruppen tragen, oder derart modifiziert sind, daß sie in wäßrig-alkalischen Lösungen löslich sind, oder solche Polymere, die aromatisch gebundene Hydroxylgruppen tragen, wie beispielsweise Kondensationsprodukte von kondensationsfähigen Carbonylverbindungen, insbesondere Formaldehyd, Acetaldehyd oder Aceton, mit Phenolen oder Copolymerisate der Hydroxystyrole. Schließlich lassen sich auch Copolymerisate des (Meth)acrylsäureamids mit Alkyl(meth)acrylaten verwenden.

Die vorstehend beschriebenen Polymeren sind insbesondere dann geeignet, wenn sie ein Molekulargewicht zwischen 500 und 200 000 oder darüber, bevorzugt 1 000 bis 100 000 aufweisen und entweder Säurezahlen zwischen 10 und 250, bevorzugt von 20 bis 200, oder Hydroxylzahlen zwischen 50 und 750, bevorzugt von 100 bis 500, aufweisen.

Als bevorzugte alkalilösliche Bindemittel seien nachstehend erwähnt:

Copolymerisate der (Meth)acrylsäure mit Alkyl(meth)acrylaten, (Meth)acrylsäurenitril oder dergleichen, Copolymerisate der Crotonsäure mit Alkyl(meth)acrylaten, (Meth)acrylsäurenitril oder dergleichen, Copolymerisate der Vinylessigsäure mit Alkyl(meth)acrylaten, Copolymerisate des Maleinsäureanhydrids mit ggf. substituierten Styrolen, ungesättigten Kohlenwasserstoffen, ungesättigten Ethern oder Estern, Veresterungsprodukte der Copolymerisate des Maleinsäureanhydrids, Veresterungsprodukte von Hydroxylgruppen enthaltenden Polymeren mit Anhydriden von Di- oder Polycarbonsäuren, Copolymerisate der Hydroxyalkyl(meth)acrylate mit Alkyl(meth)acrylaten, (Meth)acrylsäurenitril oder dergleichen, Copolymerisate des Allylalkohols mit ggf. substituierten Styrolen, Copolymerisate des Vinylalkohols mit Alkyl(meth)acrylaten oder anderen polymerisationsfähigen ungesättigten Verbindungen, Polyurethane, sofern sie eine ausreichende Anzahl freier OH-Gruppen aufweisen, Epoxyharze, Polyester, teilverseifte Vinylacetat-Copolymere, Polyvinylacetale mit freien OH-Gruppen, Copolymerisate der Hydroxystyrole mit Alkyl(meth)acrylaten oder dergleichen, Phenol-Formaldehyd-Harze, z. B. Novolake.

Die Menge des Bindemittels in der lichtempfindlichen Schicht beträgt im allgemeinen 20 bis 90, vorzugsweise bis 80 Gew.-%.

Mit dem erfindungsgemäßen Entwickler entwickelbar sind: Aufzeichnungsschichten für die photomechanische Herstellung von Druckformen für den Hochdruck, Flachdruck, Tiefdruck und Siebdruck, von Reliefkopien, z. B. Herstellung von Texten in Blindenschrift, von Einzelkopien, Gerbbildern, Pigmentbildern usw.. Besondere Bedeutung haben die Aufzeichnungsschichten für die Herstellung von Flachdruckplatten und für die Photoresisttechnik.

Als Schichtträger für das entwickelbare Aufzeichnungsmaterial sind z. B. Aluminium, Stahl, Zink, Kupfer und Kunststoff-Folien, z. B. aus Polyethylenterephthalat oder Celluloseacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen, die lithographischen Eigenschaften der Trägeroberfläche zu verbessern oder das Reflexionsvermögen des Trägers im aktinischen Bereich der Kopierschicht herabzusetzen (Lichthofschutz).

Die Herstellung der lichtempfindlichen Materialien erfolgt in bekannter Weise. So kann man die Schichtbestandteile in einem Lösemittel aufnehmen und die Lösung bzw. Dispersion durch Gießen, Sprühen, Tauchen, Antrag mit Walzen usw. auf den vorgesehenen Träger aufbringen und anschließend trocknen.

Die Belichtung des mit dem erfindungsgemäßen Entwickler entwickelbaren Aufzeichnungsmaterials kann mit allen dem Fachmann geläufigen Lichtquellen erfolgen, z.B. mit Röhren-, Xenonimpuls-, metallhalogeniddotierte Quecksilberdampf-Hochdruck- und Kohlenbogenlampen. Darüber hinaus ist das Belichten in üblichen Projektions- und Vergrößerungsgeräten unter dem Licht der Metallfadenlampen und Kontaktbelichtung mit gewöhnlichen Glühbirnen möglich. Die Belichtung kann auch mit kohärentem Licht eines Lasers erfolgen. Geeignet für die Zwecke der vorliegenden Erfindung sind leistungsgerechte Laser, beispielsweise Argon-Ionen-, Krypton-Ionen-, Farbstoff-, Helium-Cadmium- und Helium-Neon-Laser, die insbesondere zwischen 250 und 650 nm emittieren.

Die weitere Verarbeitung der Materialien wird in bekannter Weise vorgenommen. Zur besseren Vernetzung der Schicht kann eine Nacherwärmung nach dem Belichten erfolgen.

Die Erfindung betrifft auch ein Verfahren zur Herstellung einer Druckform, wobei man auf einen Träger, vorzugsweise aus Aluminium oder dessen Legierungen, der insbesondere mechanisch und/oder chemisch und/oder elektrochemisch vorbehandelt und/oder hydrophiliert ist, eine negativ arbeitende, gegebenenfalls Diazoniumsalze und/oder gegebenenfalls Bindemittel enthaltende Schicht aufbringt, die Schicht bildmäßig belichtet und anschließend mit dem erfindungsgemäßen Entwickler, der durch Verdünnen des erfindungsgemäßen Konzentrats mit Wasser hergestellt wird, entwickelt. Bei der Entwicklung von Reproduktionsschichten mit einer Deckschicht wird durch den Entwickler der gesamte Overcoat zusammen mit den unbelichteten Bereichen der photopolymerisierbaren Schicht entfernt.

Im Folgenden werden Ausführungsbeispiele für die Erfindung angegeben. Darin stehen Gewichtsteile (Gt) und Volumteile (Vt) im Verhältnis von g zu ccm. Prozent- und Mengenverhältnisse sind, wenn nichts anderes angegeben ist, in Gewichtseinheiten zu verstehen.

In der folgenden Tabelle I werden verschiedene Entwicklerzusammensetzungen gezeigt. Die Mengenangaben beziehen sich auf das jeweilige Konzentrat. Bei Verwendung der Konzentrate werden in die als Differenz bis 100 Gew.-% ermittelte Menge entionisiertes Wasser unter Rühren zunächst die Flüssigbestandteile und anschließend die Festsubstanzen gegeben. Nachdem alles homogen aufgelöst ist, wird das Konzentrat filtriert. Zum Entwickeln werden die erhaltenen Konzentrate im angegebenen Verhältnis mit Wasser verdünnt. Der pH-Wert der Entwickler liegt bei 7,5 bis 9.

Die Entwickler A und C bis F sind als Vergleichssubstanzen aufzufassen, da sie eine andere Pufferverbindung enthalten.

Die Vergleichssubstanzen C bis F zeigen alle Ausfällungen im Konzentrat und im Entwickler, während die Entwickler A und B sowie G bis M keine Phasentrennungen aufweisen und eine völlig klare Lösung liefern. Die Entwickler A und C bis F sind nicht für Schichten mit einer Deckschicht geeignet. Um den Entwickler auch bei diesen Schichten anwenden zu können, muß der Overcoat vor dem Entwickeln abgewaschen werden.

**Tabelle I**

| Entwicklerzusammensetzungen in Gewichtsprozent | | | | | | | | | | | | |
|---|---|---|---|---|---|---|---|---|---|---|---|---|
| Bestandteile | A | B | C | D | E | F | G | H | I | K | L | M |
| Pelargonsäure | 8,2 | 8,2 | 8,2 | 8,2 | 8,2 | 8,2 | 8,2 | 8,2 | 8,2 | 8,2 | 8,2 | 8,2 |
| Octylsulfat | 4,0 | 4,0 | 4,0 | 4,0 | 4,0 | 4,0 | 6,2 | 6,2 | 6,2 | 6,2 | 6,2 | 6,2 |
| Ethylenglycol-monophenylether | 6,2 | 6,2 | 6,2 | 6,2 | 6,2 | 6,2 | 6,2 | 6,2 | 6,2 | 6,2 | 6,2 | 6,2 |
| K₂B₄O₇ x 4H₂O | 2,0 | - | - | - | - | - | - | - | - | - | - | - |
| KOH fest | 2,8 | 2,8 | 2,8 | 2,8 | 2,8 | 2,8 | 2,8 | 2,8 | 2,8 | 2,8 | 2,8 | 2,8 |
| Pentanatrium-triphosphat | 4,0 | 4,0 | 4,0 | 4,0 | 4,0 | 4,0 | 3,1 | 3,1 | 3,1 | 3,1 | 3,1 | 3,1 |
| Poly-N-vinyl-N-methylacetamid | 1,0 | 1,0 | 1,0 | 1,0 | 1,0 | 1,0 | 1,0 | 1,0 | 1,0 | 1,0 | 1,0 | 1,0 |
| Tris(hydroxymethyl)-aminomethan | - | 2,0 | - | - | - | - | 0,3 | 0,6 | 1,3 | 2,0 | 2,6 | 4,0 |
| Natriumsilikat | - | - | 2,0 | - | - | - | - | - | - | - | - | - |
| Natriummetasilikat | - | - | - | 2,0 | - | - | - | - | - | - | - | - |
| Na₃PO₄ | - | - | - | - | 2,0 | - | - | - | - | - | - | - |
| Na₂HPO₄ | - | - | - | - | - | 2,0 | - | 3,3 | - | - | - | - |
| Entwicklerkonzentrat entionisiert. Wasser | ad 100 % | | | | | | | | | | | |
| Entwickler: Verdünnungsverhältn. Wasser : Konzentrat | 1 : 1 | | | | | | | | | 2:1 | 1:1 | |

In den folgenden Beispielen werden die vorher vorgestellten Entwickler getestet:

### Beispiel 1

Eine elektrochemisch aufgerauhte, anodisch oxidierte und mit einer wäßrigen Lösung von Polyvinylphosphonsäure behandelte Aluminiumfolie in Plattenform wird mit einer Lösung aus

| | |
|---|---|
| 62 Gt | eines Polymeren, hergestellt durch Rückflußerhitzung unter Verwendung eines Polyvinylbutyrals mit einem Molekulargewicht von etwa 70.000 bis 80.000, das 71 % Vinylbutyral-, 2 % Vinylacetat- und 27 % Vinylalkoholeinheiten, Maleinsäureanhydrid, Methylethylketon und Trimethylamin enthält, |
| 21 Gt | eines Diazoniumsalz-Polykondensationsproduktes, hergestellt aus 1 mol 3-Methoxy-diphenyl-amin-4-diazoniumsulfat und 1 mol 4,4'-Bismethoxymethyl-diphenylether in 85%iger Phosphorsäure und isoliert als Mesitylensulfonat, |
| 2,5 Gt | Phosphorsäure (85 %), |
| 3 Gt | Viktoriareinblau FGA (C.I.Basic Blue 81) und |
| 0,6 Gt | Phenylazodiphenylamin in |
| 2570 Gt | Ethylenglykolmonomethylether und |
| 780 Gt | Tetrahydrofuran |

beschichtet.

Die so erhaltene Kopierschicht, die nach dem Trocknen ein Schichtgewicht von 0,95 g/m aufweist, wird unter einer Negativvorlage 30 s mit einer Metallhalogenid-Lampe von 5 kW Leistung belichtet und mit den Entwicklerkonzentraten A bis M, die zuvor aurch den Zusatz von Leitungswasser im angegebenen Verhältnis verdünnt worden sind, entwickelt. Aus den oben angeführten Gründen sind nur die Entwickler hergestellt aus den Konzentraten A und B sowie G bis M zur Entwicklung der vorliegenden Kopierschicht geeignet.

Ebenso werden bei den verdünnten Konzentraten A, B und G bis M keine Trubungen oder Ausfällungen beobachtet. Die Entwicklungszeiten sind praxisgerecht und die Nichtbildstellen sauber entwickelt. Eine Fladen- oder Fädchenbildung ist nicht zu beobachten. Auch beim Einsatz der verdünnten Entwickierkonzentrate in einer üblichen Maschine zum Entwickeln und Herstellen einer Druckform mit Zwischenspülung und Gummierung sind keine entsprechenden Störungen testzustellen. Von der entwickelten Platte lassen sich in einer Offsetdruckmaschine mehrere Tausend einwandfreie Drucke anfertigen.

### Beispiel 2

Eine Lösung aus

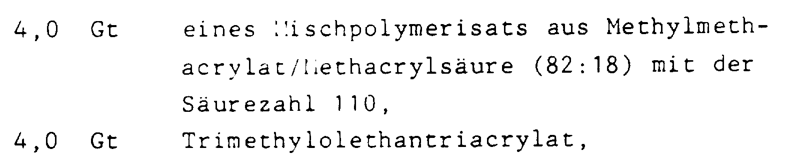

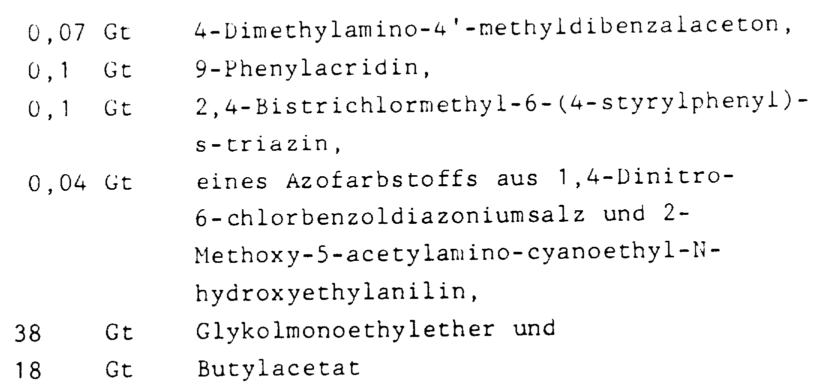

wird auf elektrolytisch aufgerauhtes und durch Anodisierung gehärtetes 0,3 mm starkes Aluminium durch Aufschleudern so aufgetragen und getrocknet, daß ein Schichtgewicht von 2,5 g/m erhalten wird.

Nach dem Trocknen wird die photopolymerisierbare Schicht mit einer Lösung von 5 Gew.-Teilen Polyvinylalkohol mit dem K-Wert 8 und 12 % unverseiften Acetylgruppen in 95 Gew.-Teilen entsalztem Wasser überschichtet und getrocknet, so daß die Deckschicht von 2,5 g/m entsteht. Anschließend wird mit der in Beispiel 1 angegebenen Lichtquelle 20 s unter einem 13-stufigen Belichtungskeil belichtet und mit den Entwicklungskonzentraten der Beispiele A bis M, die zuvor mit Leitungswasser im angegebenen Verhältnis verdünnt worden sind, entwickelt. Lediglich mit den Entwicklern B und G bis M kann ohne Schwierigkeiten entwickelt werden. Entwickler A und C bis F sind nicht in der Lage, die Deckschicht mit einer hohen Entwicklerergiebigkeit wegzulösen, die Entwickler C bis F zeigen darüber hinaus Trübungen, Ausfällungen und Phasentrennungen.

### Beispiel 3

Als Schichtträger für Druckplatten wird elektrochemisch aufgerauhtes und anodisiertes Aluminium mit einer Oxidschicht von 3 g/m verwendet, das mit einer wäßrigen Lösung von Polyvinylphosphonsäure vorbehandelt worden ist. Der Träger wird mit einer Lösung folgender Zusammensetzung überzogen:

| | |
|---|---|
| 2,84 Gt | einer 22,3 %igen Lösung eines Terpolymerisats aus Styrol, n-Hexylmethacrylat und Methacrylsäure (10:60:30) mit der Säurezahl 190 in Methylethylketon, |
| 1,49 Gt | des Umsetzungsprodukts von Triethanolamin mit 3 mol Isocyanatoethylmethacrylat, |
| 0,04 Gt | Eosin alkohollöslich (C.I. 45 386), |
| 0,03 Gt | 2,4-Bis-trichlormethyl-6-(4-styryl-phenyl)-s-triazin und |
| 0,049 Gt | 9-Phenylacridin in |
| 22 Gt | Propylenglykolmonomethylether. |

Das Auftragen erfolgt durch Aufschleudern in der Weise, daß ein Trockengewicht von 2,8 bis 3 g/m erhalten wird. Anschließend wird die Platte zwei Minuten bei 100°C im Umlufttrockenschrank getrocknet. Die Platte wird dann mit einer 15 %igen wäßrigen Lösung von Polyvinylalkohol (12 % Restacetylgruppen, K-Wert 4) beschichtet. Nach dem Trocknen wird eine Deckschicht mit einem Gewicht von 4 bis 5 g/m erhalten. Die erhaltene Druckplatte wird mittels einer 5 kW-Metallhalogenidlampe im Abstand von 110 cm unter einem 13-stufigen Belichtungskeil mit Dichteinkrementen von 0,15 belichtet, auf den, soweit angegeben, zusätzlich ein Silberfilm mit gleichmäßiger Schwärzung (Dichte 1,57) und gleichmäßiger Absorption über den wirksamen Spektralbereich als Graufilter montiert wird. Um die Empfindlichkeit der Druckplatte im sichtbaren Licht zu testen, werden auf den Belichtungskeil jeweils 3 mm starke Kantenfilter der Firma Schott mit den in der Tabelle II angegebenen Kantendurchlässigkeiten montiert. Nach der Belichtung wird die Platte eine Minute auf 100 °C erwärmt. Anschließend wird sie mit den Entwicklern A bis M entwickelt.

Das Ergebnis entspricht dem des Beispiels 2: Nur die Entwickler B und G bis M sind geeignet.

Nach dem Entwickeln wird die Platte mit fetter Druckfarbe eingefärbt. Es werden die folgenden vollvernetzten Keilstufen erhalten. Das Auflösungsvermögen der Druckplatte wird mit einer Testvorlage, dem PMS-Keil (FOGRA), bestimmt und an der Kopie abgelesen.

**Tabelle II**

| Belichtung (Sekunden) | Graufilter | Kantenfilter | Keilstufen | Auflösung (µm) |
|---|---|---|---|---|
| 10 | ja | - | 11 | 25 |
| 10 | nein | 455 | 9 | 25 |

### Beispiele 4 bis 10

Auf das Trägermaterial und die Photopolymerschicht aus Beispiel 3 werden sauerstoffinhibierende Deckschichten aus folgenden Lösungen zu einem Trockenschichtgewicht von etwa 2 g/m aufgebracht:

| | |
|---|---|
| 100 Gt | einer 7%igen wäßrigen Lösung von Polyvinylalkohol (12 % Restacetylgruppen, K-Wert 4, d.h. Viskosität einer 4%igen wäßrigen Lösung bei 20 °C: 4,0 mPa·s), |
| 0,4 Gt | Polymeres gemäß Tabelle II. |

Die Ergebnisse sind in Tabelle III zusammengefaßt.

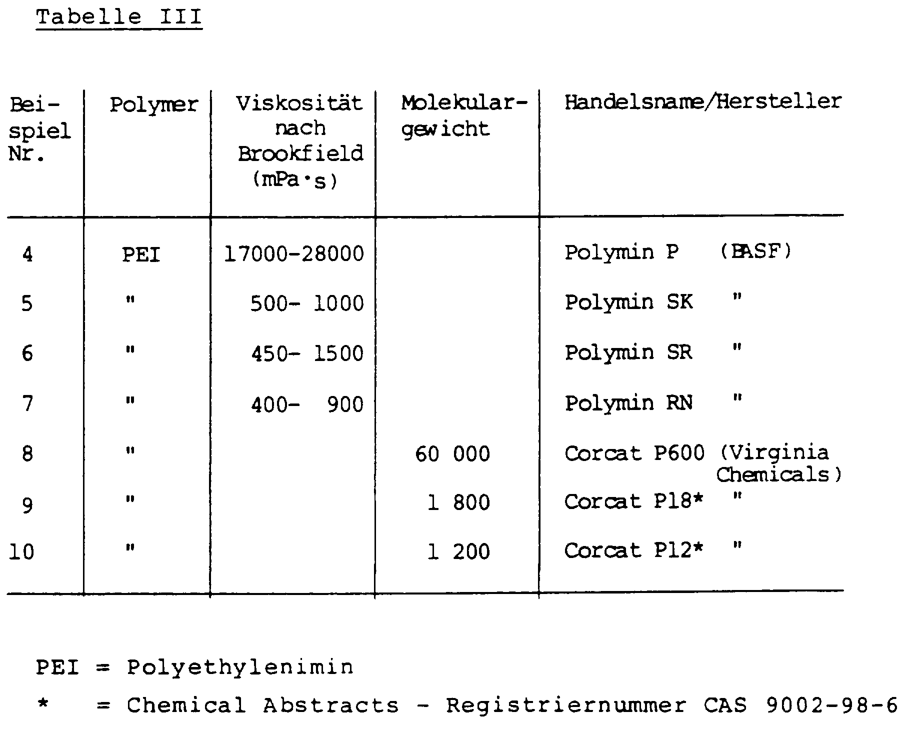

Die Druckplatten werden wie in Beispiel 3 angegeben verarbeitet. Die Entwicklung wird mit dem Entwickler K in der Verdünnung 2:1 durchgeführt.

Tabelle IV faßt die Ergebnisse zusammen. Die angegebenen vollvernetzten Keilstufen werden unter dem Kantenfilter 455 nm bei einer Belichtungszeit von 10 s erhalten.

**Tabelle IV**

| Beispiel | 4 | 5 | 6 | 7 | 8 | 9 | 10 |
|---|---|---|---|---|---|---|---|
| Keilstufen | 7 | 8 | 8 | 7 | 8 | 8 | 7 |

Bei dem verdünnten Konzentrat des Entwicklers K werden keine Trübungen oder Ausfällungen beobachtet. Die Entwicklungszeiten sind praxisgerecht und die Nichtbildstellen sauber entwickelt. Eine Fladen- oder Fädchenbildung ist nicht zu beobachten. Auch beim Einsatz der verdünnten Entwicklerkonzentrate in einer üblichen Maschine zum Entwickeln und Herstellen einer Druckform mit Zwischenspülung und Gummierung sind keine entsprechenden Störungen festzustellen. Von der entwickelten Platte lassen sich in einer Offsetdruckmaschine mehrere Tausend einwandfreie Drucke anfertigen.

Auch die in den folgenden Beispielen vorgestellten lichtempfindlichen Schichten sind nach dem Auftragen auf einen Träger und anschließender bildmäßiger Belichtung mit den erfindungsgemäßen Entwicklern gut entwickelbar.

### Beispiel 11

Aus den folgenden Bestandteilen wird eine lichtempfindliche Schicht hergestellt:

| | |
|---|---|
| 0,45 Gt | eines Copolymeren aus 82 % Methylmethacrylat und 18 % Methacrylsäure (Säurezahl 117), |
| 1,05 Gt | eines Polymeren, hergestellt durch Rückflußerhitzung unter Verwendung eines Polyvinylbutyrals mit einem Molekulargewicht von etwa 70- bis 80.000, das 71 % Vinylbutyral, 2 % Vinylacetat und 27 % Vinylalkoholeinheiten, Maleinsäureanhydrid, Methylethylketon und Trimethylamin enthält, |
| 0,45 Gt | des Diazoniumsalz-Polykondensationsproduktes gemäß Beispiel 1, |
| 0,04 Gt | 85%ige Phosphorsäure, |
| 0,09 Gt | Viktoriareinblau FGA (C.I. Basic Blue 81), |
| 1,5 Gt | Pentaerythrittetraacrylat/-triacrylat (techn. Gemisch), |
| 0,007 Gt | Phenylazodiphenylamin, |
| 0,12 Gt | 2-(4-Styryl-phenyl)-4,6-bis-trichlormethyl-s-triazin in |
| 47,7 Gt | Ethylenglykolmonomethylether und |
| 48,6 Gt | Butanon. |

Das Schichtgewicht nach dem Trocknen beträgt 1,8 g/m.

Die Platte wird dann mit einer 15%igen wäßrigen Lösung von Polyvinylalkohol (12 % Restacetylgruppen, K-Wert 4) beschichtet. Nach dem Trocknen wird eine Deckschicht mit einem Gewicht von 1 g/m erhalten.

Die erhaltene Schicht ist mit den Entwicklern B und G bis M gut entwickelbar.

### Beispiel 12

Aus den folgenden Bestandteilen wird eine lichtempfindliche Schicht hergestellt:

| | |
|---|---|
| 2,0 Gt | eines teilweise mit Alkanol veresterten Styrol-Maleinsäureanhydrid-Mischpolymerisats mit einem mittleren Molekulargewicht von 20.000 und einer Säurezahl um 200, |
| 2,0 Gt | eines Diurethans, hergestellt durch Umsetzung von Glycerindimethacrylat mit Hexamethylendiisocyanat, |
| 0,125 Gt | 9-Phenylacridin, |
| 0,05 Gt | eines blauen Farbstoffes, erhalten durch Kuppeln von 2,4-Dinitro-6-chlor-benzol-diazoniumsalz mit 2-Methoxy-5-acetamino-N-cyanoethyl-N-hydroxyethylanilin in |
| 25,0 Gt | Butanon und |
| 12,0 Gt | Butylacetat. |

Das Schichtgewicht nach dem Trocknen beträgt 3,7 g/m. Die erhaltene Schicht ist mit den Entwicklern A und B sowie G bis M gut entwickelbar.

## Patentansprüche

1. Entwicklerkonzentrat, bestehend aus einem Gemisch aus Wasser, einem organischen Lösemittel, einem alkalisch reagierenden Mittel, einem anionischen Tensid, einer n-Alkansäure und/oder deren Salze, einem Emulgator, einem Alkalisalz eines oligomeren Phosphats und/oder der N-(2-Hydroxyethyl)ethylendiaminotriessigsäure als Komplexbildner und einer Puffersubstanz, dadurch gekennzeichnet, daß die Puffersubstanz ein Tris(hydroxyalkyl)aminomethan ist.

2. Entwicklerkonzentrat nach Anspruch 1, dadurch gekennzeichnet, daß der Gehalt an Puffersubstanz im Konzentrat 0,5 bis 20,0 Gew.-%, vorzugsweise 0,7 bis 10,0 Gew.-%, beträgt.

3. Entwicklerkonzentrat nach einem der Ansprüche 1 oder 2, dadurch gekennzeichnet, daß die Puffersubstanz ein Tris(hydroxy(C₁-C₄)alkyl)aminomethan, insbesondere Tris(hydroxymethyl)aminomethan, ist.

4. Entwicklerkonzentrat nach einem der Ansprüche 1 bis 3, dadurch gekennzeichnet, daß der Gehalt an Komplexbildner im Konzentrat 0,1 bis 9,0 Gew.-%, vorzugsweise 0,5 bis 6,0 Gew.-%, beträgt.

5. Entwicklerkonzentrat nach einem der Ansprüche 1 bis 4, dadurch gekennzeichnet, daß der Komplexbildner das Alkalisalz eines Oligophosphats mit 2 bis 10, insbesondere 2 bis 6, Phosphoreinheiten ist.

6. Entwicklerkonzentrat nach einem der Ansprüche 1 bis 5, dadurch gekennzeichnet, daß der Komplexbildner das Natriumsalz der N-(2-Hydroxyethyl)-ethylendiaminotriessigsäure ist.

7. Entwicklerkonzentrat nach einem der Ansprüche 1 bis 6, dadurch gekennzeichnet, daß die n-Alkansäure und/oder deren Salze 8 bis 12 Kohlenstoffatome aufweist/aufweisen.

8. Entwicklerkonzentrat nach einem der Ansprüche 1 bis 7, dadurch gekennzeichnet, daß der Gehalt an n-Alkansäure im Konzentrat 1,0 bis 16,0 Gew.-%, vorzugsweise 1,5 bis 14,0 Gew.-%, beträgt.

9. Entwicklerkonzentrat nach einem der Ansprüche 1 bis 8, dadurch gekennzeichnet, daß die n-Alkansäure und/oder deren Salze ausgewählt sind aus der Gruppe Capryl-, Pelargon-, Caprin- und Laurinsäure.

10. Entwicklerkonzentrat nach einem der Ansprüche 1 bis 9, dadurch gekennzeichnet, daß der Gehalt an anionischem oberflächenaktivem Mittel im Konzentrat 0,2 bis 15,0 Gew.-%, vorzugsweise 1,0 bis 8,0 Gew.-%, beträgt.

11. Entwicklerkonzentrat nach einem der Ansprüche 1 bis 10, dadurch gekennzeichnet, daß wenigstens ein anionisches oberflächenaktives Mittel ausgewählt ist aus der Gruppe Alkali-, vorzugsweise Natrium-, -octylsulfat, -dodecylbenzolsulfonat, -alkylphenolethersulfate, -naphthalensulfonate, -sulfosuccinate, -alkyletherphosphate oder Alkali-, vorzugsweise Natrium-ölsäuremethyltaurid.

12. Entwicklerkonzentrat nach einem der Ansprüche 1 bis 11, dadurch gekennzeichnet, daß der Gehalt an Emulgator im Konzentrat 0,1 bis 10,0, vorzugsweise 0,2 bis 6,0, Gew.-% beträgt.

13. Entwicklerkonzentrat nach einem der Ansprüche 1 bis 12, dadurch gekennzeichnet, daß wenigstens ein Emulgator ausgewählt ist aus der Gruppe Poly-N-vinyl-N-methylacetamid, wasserlösliche Copolymere des N-Vinyl-N-methylacetamid, Polyvinylalkohol, Dextrin, Gummi arabicum und Celluloseether, insbesondere Carboxymethylcellulose.

14. Entwicklerkonzentrat nach einem der Ansprüche 1 bis 13, dadurch gekennzeichnet, daß der Gehalt an organischem Lösemittel im Konzentrat 0,5 bis 15,0 Gew.-%, vorzugsweise 1,0 bis 10,0 Gew.-%, beträgt.

15. Entwicklerkonzentrat nach einem der Ansprüche 1 bis 14, dadurch gekennzeichnet, daß wenigstens ein organisches Lösemittel ausgewählt ist aus der Gruppe Benzylalkohol, Phenoxyethanol, 1-Phenylethanol, 2-Phenylethanol und Propylenglykolmonomethyl und -phenylether.

16. Entwicklerkonzentrat nach einem der Ansprüche 1 bis 15, dadurch gekennzeichnet, daß als alkalisch reagierendes Mittel ein Alkalimetallhydroxid verwendet wird.

17. Entwickler zum Entwickeln einer auf einem Träger befindlichen negativ arbeitenden belichteten Reproduktionsschicht, dadurch gekennzeichnet, daß das Konzentrat nach einem der Ansprüche 1 bis 16 mit Leitungswasser verdünnt wird.

18. Entwickler nach Anspruch 17, dadurch gekennzeichnet, daß das Verdünnungsverhältnis von Konzentrat zu Leitungswasser 1:0,5 bis 1:6 beträgt.

19. Verfahren zur Herstellung einer Druckform, wobei man auf einen Träger eine negativ arbeitende, Diazoniumsalz-Polykondensationsharz enthaltende Schicht aufbringt, die Schicht bildmäßig belichtet und anschließend mit einem Entwickler nach einem der Ansprüche 17 oder 18 entwickelt.

20. Verfahren zur Herstellung einer Druckform, wobei man auf einen Träger eine negativ arbeitende, eine photopolymerisierbare Verbindung enthaltende Schicht aufbringt, die Schicht bildmäßig belichtet und mit einem Entwickler gemäß einem der Ansprüche 17 oder 18 entwickelt.

21. Verfahren zur Herstellung einer Druckform, wobei man auf einen Träger eine negativ arbeitende, sowohl ein Diazoniumsalz-Polykondensationsharz als auch eine photopolymerisierbare Verbindung enthaltende Schicht aufbringt, die Schicht bildmäßig belichtet und mit einem Entwickler gemäß einem der Ansprüche 17 oder 18 entwickelt.

## Claims

1. A developer concentrate composed of a mixture of water, one organic solvent, one agent with an alkaline reaction, one anionic surfactant, one n-alkanoic acid and/or its salts, one emulsifier, one alkali-metal salt of an oligomeric phosphate and/or of N-(2-hydroxyethyl)ethylenediaminotriacetic acid as complexing agent and one buffering substance, wherein the buffer substance is a tris(hydroxyalkyl)aminomethane.

2. A developer concentrate as claimed in claim 1, wherein the content of buffering substance in the concentrate is 0.5 to 20.0 % by weight, preferably 0.7 to 10.0 % by weight.

3. A developer concentrate as claimed in either of claims 1 or 2, wherein the buffering substance is a tris(hydroxy(C₁-C₄)alkyl)aminomethane, in particular tris(hydroxymethyl)aminomethane.

4. A developer concentrate as claimed in any of claims 1 to 3, wherein the content of complexing agent in the concentrate is 0.1 to 9.0 % by weight, preferably 0.5 to 6.0 % by weight.

5. A developer concentrate as claimed in any of claims 1 to 4, wherein the complexing agent is the alkali-metal salt of an oligophosphate containing 2 to 10, in particular 2 to 6, phosphorus units.

6. A developer concentrate as claimed in any of claims 1 to 5, wherein the complexing agent is the sodium salt of N-(2-hdyroxyethyl)ethylenediaminotriacetic acid.

7. A developer concentrate as claimed in any of claims 1 to 6, wherein the n-alkanoic acid and/or its salts has/have 8 to 12 carbon atoms.

8. A developer concentrate as claimed in any of claims 1 to 7, wherein the content of n-alkanoic acid in the concentrate is 1.0 to 16.0 % by weight, preferably 1.5 to 14.0 % by weight.

9. A developer concentrate as claimed in any of claims 1 to 8, wherein the n-alkanoic acid and/or its salts are selected from the group comprising caprylic, pelargonic, capric and lauric acid.

10. A developer concentrate as claimed in any of claims 1 to 9, wherein the content of anionic surface-active agent in the concentrate is 0.2 to 15.0 % by weight, preferably 1.0 to 8.0 % by weight.

11. A developer concentrate as claimed in any of claims 1 to 10, wherein at least one anionic surface-active agent is selected from the group comprising alkali-metal, preferably sodium, octyl sulfate, dodecylbenzenesulfonate, alkyl phenol ether sulfates, naphthalenesulfonates, sulfosuccinates, alkyl ether phosphates or alkali-metal, preferably sodium oleic acid methyl tauride.

12. A developer concentrate as claimed in any of claims 1 to 11, wherein the content of emulsifier in the concentrate is 0.1 to 10.0, preferably 0.2 to 6.0 % by weight.

13. A developer concentrate as claimed in any of claims 1 to 12, wherein at least one emulsifier is selected from the group comprising poly-N-vinyl-N-methylacetamide, water soluble copolymers of N-vinyl-N-methylacetamide, polyvinyl alcohol, dextrin, gum arabic and cellulose ethers, in particular carboxymethyl cellulose.

14. A developer concentrate as claimed in any of claims 1 to 13, wherein the content of organic solvent in the concentrate is 0.5 to 15.0 % by weight, preferably 1.0 to 10.0 % by weight.

15. A developer concentrate as claimed in any of claims 1 to 14, wherein at least one organic solvent is selected from the group comprising benzyl alcohol, phenoxyethanol, 1-phenylethanol, 2-phenylethanol and propylene glycol monomethyl and -phenyl ether.

16. A developer concentrate as claimed in any of claims 1 to 15, wherein an alkali-metal hydroxide is used as agent with alkaline reaction.

17. A developer for developing a negative-working exposed reproduction layer on abase, wherein the concentrate as claimed in any of claims 1 to 16 is diluted with tap water.

18. A developer as claimed in claim 17, wherein the dilution ratio of concentrate to tap water is 1:0.5 to 1:6.

19. A process for preparing a printing form which comprises applying a negative-working layer containing diazonium salt polycondensation resin to a base, exposing the layer to an image and then developing it with a developer as claimed in either of claims 17 or 18.

20. A process for producing a printing form, which comprises applying a negative-working layer containing a photopolymerizable compound to a base, exposing the layer imagewise and developing it with a developer as claimed in either of claims 17 or 18.

21. A process for producing a printing form, which comprises applying a negative-working layer containing both a diazonium salt polycondensation resin and a photopolymerizable compound to a base, exposing the layer imagewise and developing it with a developer as claimed in either of claims 17 or 18.

## Revendications

1. Concentré de révélateur, constitué d'un mélange d'eau, d'un solvant organique, d'un agent à caractère basique, d'un tensioactif anionique, d'un acide n-alcanoïque et/ou de ses sels, d'un émulsifiant, d'un sel alcalin d'un phosphate oligomère et/ou de l'acide N-(2-hydroxyéthyl)éthylènediaminetriacétique en tant que complexant et d'une substance tampon, caractérisé en ce que la substance tampon est un tris(hydroxyalkyl)aminométhane.

2. Concentré de révélateur selon la revendication 1, caractérisé en ce que la teneur du concentré en substance tampon va de 0,5 à 20,0 % en poids, de préférence de 0,7 à 10,0 % en poids.

3. Concentré de révélateur selon la revendication 1 ou 2, caractérisé en ce que la substance tampon est un tris(hydroxyalkyl[C₁-C₄])aminométhane, en particulier le tris(hydroxyméthyl)aminométhane.

4. Concentré de révélateur selon l'une des revendications 1 à 3, caractérisé en ce que la teneur du concentré en complexant va de 0,1 à 9,0 % en poids, de préférence de 0,5 à 6,0 % en poids.

5. Concentré de révélateur selon l'une des revendications 1 à 4, caractérisé en ce que le complexant est un sel alcalin d'un oligophosphate comportant de 2 à 10, en particulier de 2 à 6 groupes phosphorés.

6. Concentré de révélateur selon l'une des revendications 1 à 5, caractérisé en ce que le complexant est le sel sodique de l'acide N-(2-hydroxyéthyl)éthylènediaminetriacétique.

7. Concentré de révélateur selon l'une des revendications 1 à 6, caractérisé en ce que l'acide n-alcanoïque et/ou ses sels comporte(nt) de 8 à 12 atomes de carbone.

8. Concentré de révélateur selon l'une des revendications 1 à 7, caractérisé en ce que la teneur du concentré en acide n-alcanoïque va de 1,0 à 16,0 % en poids, de préférence de 1,5 à 14,0 % en poids.

9. Concentré de révélateur selon l'une des revendications 1 à 8, caractérisé en ce que l'acide n-alcanoïque et/ou ses sels sont choisis parmi les acides caprylique, pélargonique, caprique et laurique.

10. Concentré de révélateur selon l'une des revendications 1 à 9, caractérisé en ce que la teneur du concentré en agent tensioactif anionique va de 0,2 à 15,0 % en poids, de préférence de 1,0 à 8,0 % en poids.

11. Concentré de révélateur selon l'une des revendications 1 à 10, caractérisé en ce qu'au moins un agent tensioactif est choisi parmi un octylsulfate, un dodécylbenzènesulfonate, des alkylphénoléthersulfates, naphtalènesulfonates, sulfosuccinates, alkylétherphosphates alcalins, de préférence de sodium, et un sel alcalin, de préférence de sodium, d'oléylméthyltaurine.

12. Concentré de révélateur selon l'une des revendications 1 à 11, caractérisé en ce que la teneur du concentré en émulsifiant va de 0,1 à 10,0, de préférence de 0,2 à 6,0 % en poids.

13. Concentré de révélateur selon l'une des revendications 1 à 12, caractérisé en ce qu'au moins un émulsifiant est choisi parmi le poly-N-vinyl-N-méthylacétamide, des copolymères hydrosolubles du N-vinyl-N-méthylacétamide, le poly(alcool vinylique), la dextrine, la gomme arabique et des éthers de cellulose, en particulier la carboxyméthylcellulose.

14. Concentré de révélateur selon l'une des revendications 1 à 13, caractérisé en ce que la teneur du concentré en solvant organique va de 0,5 à 15,0 % en poids, de préférence de 1,0 à 10,0 % en poids.

15. Concentré de révélateur selon l'une des revendications 1 à 14, caractérisé en ce qu'au moins un solvant organique est choisi parmi l'alcool benzylique, le phénoxyéthanol, le 1-phényléthanol, le 2-phényléthanol et les éthers monométhylique et -phénylique de propylèneglycol.

16. Concentré de révélateur selon l'une des revendications 1 à 15, caractérisé en ce que, comme agent à caractère basique, on utilise un hydroxyde de métal alcalin.

17. Révélateur pour le développement d'une couche de reprographie insolée, travaillant en négatif et se trouvant sur un support, caractérisé en ce que le concentré selon l'une des revendications 1 à 16 est dilué avec de l'eau du robinet.

18. Révélateur selon la revendication 17, caractérisé en ce que le rapport de dilution du concentré à l'eau du robinet va de 1:0,5 à 1:6.

19. Procédé pour l'obtention d'une forme d'impression, dans lequel on applique sur un support une couche travaillant en négatif, contenant une résine de polycondensation d'un sel de diazonium, et la couche est insolée selon l'image et ensuite développée avec un révélateur selon la revendication 17 ou 18.

20. Procédé pour l'obtention d'une forme d'impression, dans lequel on applique sur un support une couche travaillant en négatif, contenant un composé photopolymérisable, et la couche est insolée selon l'image et ensuite développée avec un révélateur selon la revendication 17 ou 18.

21. Procédé pour l'obtention d'une forme d'impression, dans lequel on applique sur un support une couche travaillant en négatif, contenant aussi bien une résine de polycondensation d'un sel de diazonium qu'un composé photopolymérisable, et la couche est insolée selon l'image et ensuite développée avec un révélateur selon la revendication 17 ou 18.
